# FASCICULE DE BREVET EUROPEEN

(11) **EP 2 795 685 B1**
(45) Date de publication et mention de la délivrance du brevet: **16.01.2019**
(21) Numéro de dépôt: 12806047.2
(22) Date de dépôt: 19.12.2012
(51) Int. Cl.: H01L 31/0304, H01L 31/0352, H01L 31/18, H01L 31/20, H01L 21/02, H01L 33/00, H01L 33/18, H01L 31/0735, H01L 33/12, H01L 33/40, H01L 33/08

(54) **PROCEDE DE FABRICATION D'UN MICRO- OU NANO- FIL SEMICONDUCTEUR, STRUCTURE SEMICONDUCTRICE COMPORTANT UN TEL MICRO- OU NANO- FIL ET PROCEDE DE FABRICATION D'UNE STRUCTURE SEMICONDUCTRICE**
VERFAHREN ZUR HERSTELLUNG EINES HALBLEITERMIKRO- ODER NANODRAHTES, HALBLEITERSTRUKTUR MIT EINEM SOLCHEN MIKRO- ODER NANODRAHT UND VERFAHREN ZUM HERSTELLEN EINER HALBLEITERSTRUKTUR
METHOD FOR MANUFACTURING A SEMICONDUCTOR MICRO- OR NANOWIRE, SEMICONDUCTOR STRUCTURE COMPRISING SUCH A MICRO- OR NANOWIRE, AND METHOD FOR MANUFACTURING A SEMICONDUCTOR STRUCTURE

(30) Priorité: 20.12.2011 FR 1162029; 09.01.2012 US 201261584401 P
(43) Date de publication de la demande: 29.10.2014
(73) Titulaire: Commissariat à l'Énergie Atomique et aux Énergies Alternatives, 75015 Paris (FR)
(72) Inventeur: DUSSAIGNE, Amélie, F-38690 Bizonnes (FR); GILET, Philippe, F-38470 Teche (FR); MARTIN, François, F-38000 Grenoble (FR)
(74) Mandataire: Brevalex
(86) Numéro de dépôt international: PCT/EP2012/076091
(87) Numéro de publication internationale: WO 2013/092665

(56) Documents cités:
- EP-A2- 1 727 216
- DE-A1-102007 022 921
- US-A1- 2005 224 824
- US-A1- 2008 036 038
- TUN C ET AL: "Dislocation reduction in GaN with multiple MgxNy/GaN buffer layers by metal organic chemical vapor deposition", APPLIED PHYSICS LETTERS, AIP, AMERICAN INSTITUTE OF PHYSICS, MELVILLE, NY, US, vol. 90, no. 21, 22 mai 2007 (2007-05-22), pages 212109-212109, XP012094948, ISSN: 0003-6951, DOI: 10.1063/1.2742590
- FU Y K ET AL: "Nitride-based blue light-emitting diodes with multiple MgxNy/GaN buffer layers", SOLID STATE ELECTRONICS, ELSEVIER SCIENCE PUBLISHERS, BARKING, GB, vol. 54, no. 5, 1 mai 2010 (2010-05-01), pages 590-594, XP026965986, ISSN: 0038-1101 [extrait le 2010-03-13]

## Description

### DOMAINE TECHNIQUE

L'invention se rapporte au domaine de la détection, de la mesure et de l'émission de rayonnements électromagnétiques et aux dispositifs permettant la détection, la mesure ou l'émission de rayonnements électromagnétiques.

Ces dix dernières années ont été marquées par un fort développement de l'optoélectronique et des dispositifs qui en découlent. De tels dispositifs mettent en oeuvre des structures semiconductrices qui sont adaptées pour la détection, la mesure ou l'émission de rayonnements électromagnétiques.

Parmi ces structures, les structures semiconductrices à base de micro- ou de nano- fils démontrent un fort potentiel quant aux rendements atteignables que ce soit pour la réception, dans le cas de la détection et la mesure, ou l'émission, de rayonnements électromagnétiques. Ces rendements sont également suffisamment importants pour envisager l'utilisation de telles structures dans les applications photovoltaïques.

De telles structures, qu'elles soient dédiées à la détection, la mesure ou l'émission d'un rayonnement électromagnétique ou aux applications photovoltaïques, peuvent être dénommées plus généralement structures opto-électriques.

On entend donc ci-dessus et dans le reste de ce document par structure opto-électrique tout type de structure semiconductrice adaptée pour effectuer la conversion d'un signal électrique en un rayonnement électromagnétique ou inversement.

L'invention se rapporte plus particulièrement à un procédé de fabrication d'au moins un micro- ou nano- fil semiconducteur, à une structure semiconductrice destinée à émettre un rayonnement électromagnétique, à une structure semiconductrice apte à recevoir un rayonnement électromagnétique et à le convertir en un signal électrique et à un procédé de fabrication d'une structure opto-électrique.

### ÉTAT DE LA TECHNIQUE ANTÉRIEURE

Les structures semiconductrices opto-électriques à base de micro- ou nano- fils comportent généralement un support semiconducteur pourvu de micro- ou nano- fils semiconducteurs et de moyens de connexions électriques desdits micro- ou nano- fils. Afin de permettre la conversion d'un signal électrique en un rayonnement électromagnétique ou l'inverse, lesdits micro- ou nano- fils présentent chacun une zone active telle qu'une jonction semiconductrice apte à permettre une telle conversion.

Cette zone active doit être adaptée pour soit l'absorption ou soit l'émission d'un rayonnement électromagnétique, ceci afin de permettre soit la conversion d'un rayonnement électromagnétique en un signal électrique ou soit l'inverse. Dans ces deux cas l'adaptation nécessite notamment que chacune des zones actives des micro- ou nano- fils soit au moins partiellement réalisée dans un ou plusieurs matériaux semiconducteurs à gap direct.

On entend par matériau semiconducteur à gap direct un matériau semiconducteur dont le maximum d'énergie de la bande de valence et le minimum d'énergie de la bande de conduction se situent à une valeur du vecteur d'onde k sensiblement égale dans le diagramme de dispersion énergétique dudit matériau semiconducteur.

Parmi ces matériaux semiconducteurs à gap direct, les nitrures semiconducteurs à gap direct, tels que le nitrure de gallium (GaN), sont les matériaux semiconducteurs les plus utilisés pour les applications opto-électriques. Pour une telle zone active, en raison de limitations techniques liées au procédé de fabrication des micro- ou nano- fils, la partie de chacun des micro- ou nano- fils qui est en contact avec le support est également réalisée dans un nitrure semiconducteur à gap direct.

Les documents EP1727216 A2, US20080036038 A1 et US20050224824 A1 divulguent des structures semi-conductrice opto-électriques connues dans l'état de la technique antérieure.

Ainsi les procédés de fabrication d'une structure opto-électrique à base de micro- ou nano- fils dont la zone active est au moins partiellement en nitrure semiconducteur à gap direct, comporte une étape de mise en oeuvre d'un procédé de formation des micro- ou nano- fils sur un substrat, dont la partie des micro- ou nano- fils qui est en contact avec le substrat est en nitrure semiconducteur.

Un tel procédé de formation des micro- ou nano- fils comporte généralement les étapes consistant à :
- fournir un substrat semiconducteur comportant une première et une seconde face,
- former une couche, dite tampon, sur la première face du substrat, la couche étant constituée de nitrure d'aluminium,
- former les micro- ou nano- fils semiconducteurs sur la couche tampon, la partie dudit micro- ou nano- fil, dite de contact, étant principalement constituée de nitrure semiconducteur à gap direct, ladite partie étant la partie du micro- ou nano- fil en contact avec la couche tampon.

L'étape de formation de la couche tampon est une étape qui, si elle est accessoire pour certains types de substrats en combinaison avec une étape de formation des micro- ou nano- fils adéquate, est néanmoins généralement mise en oeuvre pour garantir la qualité cristalline des micro- ou nano- fils.

En effet, la couche tampon permet de réaliser une adaptation de la maille cristalline entre celle du substrat et celle des micro- ou nano- fils limitant ainsi les contraintes liées à l'hétéroépitaxie. Elle permet également, pour certains types de procédé d'épitaxie utilisés lors de l'étape de croissance des micro- ou nano- fils, de protéger la surface du substrat contre une possible interaction de cette dernière avec certains des éléments constituant les micro- ou nano- fils, tels que le gallium (Ga), qui pourraient engendrer des défauts à la surface du substrat.

Pour offrir, à la fois la fonction d'adaptation du paramètre de maille et de protection du substrat, il est connu de former la couche tampon en nitrure d'aluminium (AIN).

Néanmoins si une telle couche tampon permet bien une formation de micro- ou nano- fils de qualité sans risque de contamination du substrat, elle présente un certain nombre d'inconvénients. En effet, le nitrure d'aluminium est un semiconducteur très grand gap, qui présente donc une faible conductivité et se comporte donc comme un semi-isolant.

Une telle couche tampon ne permet donc pas, pour cette raison, de fournir une résistance électrique entre le substrat et les micro- ou nano- fils qui soit faible. Il en résulte que les structures opto-électriques utilisant une telle couche tampon présente généralement des tensions de fonctionnement relativement importantes.

De plus, une couche tampon de nitrure d'aluminium présente une surface de nucléation de polarité aluminium. Or la croissance de micro- ou nano- fils de nitrure de gallium, nécessite, idéalement, une surface de nucléation de polarité azote. En effet, avec une polarité autre que l'azote, telle qu'une polarité aluminium, les conditions de formation du micro- ou nano- fil doivent être précisément déterminées afin d'éviter la formation d'un autre type de structure tel qu'une structure du type pyramidal. Il en résulte donc que l'utilisation d'une couche tampon en nitrure d'aluminium induit nécessairement une longue et coûteuse procédure d'étalonnage du procédé de fabrication du micro- ou nano- fil afin que l'étape de formation de ce dernier ne donne pas lieu à la croissance d'une structure de type pyramidal en lieu et place du micro- ou nano- fil.

### EXPOSÉ DE L'INVENTION

La présente invention vise à remédier à ces inconvénients.

Un but de l'invention est donc de fournir un procédé de fabrication d'au moins un micro- ou nano- fil sur un substrat, le procédé permettant de fournir au moins un micro- ou nano- fil de bonne qualité cristalline avec une résistance électrique entre le substrat et le nano- fil qui est réduite par rapport aux micro- ou nano- fils obtenus selon un procédé de l'art antérieur, ceci quelle que soit la méthode de croissance épitaxiale mise en oeuvre pour l'étape de formation du micro- ou nano- fil.

Un autre but de l'invention est de fournir un procédé de fabrication d'au moins un micro- ou nano- fil en semi-conducteur nitruré qui comporte une étape de formation du micro- ou nano- fil qui a lieu sur une surface de nucléation de polarité azote, ceci avec une résistance électrique entre le substrat et le micro- ou nano- fil qui est réduite par rapport aux micro- ou nano- fils obtenus selon un procédé de l'art antérieur.

A cet effet, l'invention concerne un procédé de fabrication d'au moins un micro- ou nano- fil semiconducteur destiné à la formation d'une structure opto-électrique, ledit procédé comportant les étapes consistant à :
- fournir un substrat semiconducteur comportant une première et une seconde face,
- former une couche cristalline, dite tampon, sur la première face du substrat, la couche tampon présentant sur au moins une partie de son épaisseur une première zone en contact avec la seconde face, la première zone étant principalement composée de nitrure de magnésium sous la forme MgₓN_{y},
- former au moins un micro- ou nano- fil semiconducteur sur la couche tampon, au moins une partie dudit micro- ou nano- fil, dite de contact, étant principalement constituée de nitrure semiconducteur à gap direct, ladite partie étant la partie du micro- ou nano- fil en contact avec la couche tampon.

On entend par « principalement composée de nitrure de magnésium » une composition comportant une proportion de nitrure de magnésium qui est supérieure ou égale à 95%, cette proportion étant préférentiellement supérieure à 99%.

On entend également par « principalement constitué » que la composition comporte une proportion supérieure ou égale à 95% dudit matériau, cette proportion étant préférentiellement supérieure à 99%.

Une telle couche tampon, par la présence d'une zone principalement composée de nitrure de magnésium sous sa forme MgₓN_{y} et par sa qualité cristalline, permet la croissance d'au moins un micro- ou nano- fil principalement constitué de nitrure semiconducteur avec une bonne adaptation du paramètre de maille par rapport à un substrat semi-conducteur tel qu'un substrat en silicium ou en carbure de silicium, et donc une croissance d'au moins un micro- ou nano- fil avec une faible concentration en défauts cristallins. De plus, une telle couche présente, par rapport à la couche tampon utilisée dans l'art antérieur, une résistance d'interface plus faible puisque possédant une bande interdite réduite par rapport à la couche tampon de l'art antérieur. Ainsi un tel procédé permet la fabrication de structure dont la tension de polarisation du ou des micro- ou nano- fils réduite, les résistances d'interface entre chacun des micro- ou nano- fils et la couche tampon étant faibles.

De plus une telle couche tampon permet également, lorsque le micro- ou nano- fil présente un premier type de conductivité dont les porteurs majoritaires sont des électrons, de présenter ce même type de conductivité ceci en contrôlant la proportion relative d'azote dans la couche tampon.

Une telle couche tampon permet également de fournir une surface de nucléation pour la formation du micro- ou nano- fil qui présente une polarité azote et qui est donc particulièrement adaptée pour la croissance de micro- ou nano- fils en nitrure semiconducteur.

La partie de contact du micro- ou nano- fil peut être constituée de nitrure de gallium.

Un tel procédé est particulièrement adapté pour la fourniture d'un micro- ou nano- fil de nitrure de gallium (GaN) puisque la formation du micro- ou nano-fil a lieu sur une surface de nucléation présentant une polarité azote qui est particulièrement appropriée pour la formation de micro- ou nano- fils, c'est-à-dire de structures filaires.

En effet, une couche de nucléation présentant une telle polarité permettra d'obtenir des micro- ou nano- structures de forme filaire et non pas pyramidale. Une telle structure filaire, ou micro- ou nano- fil, présente ainsi au moins une partie verticale suivant le plan cristallographique m. Cette partie verticale suivant le plan m peut être située au niveau de la partie du fil en contact avec la couche de nucléation. La partie en contact du micro- ou nano- fil peut présenter, sur sa surface qui est en contact avec la couche tampon, une polarité azote.

Dans l'étape de formation de la couche tampon, la couche tampon peut être principalement composée de nitrure de magnésium sous la forme MgₓN_{y}.

Ainsi après l'étape de formation de la couche tampon, celle-ci présente une surface, celle opposée à la première face du substrat, qui est adaptée pour la croissance du micro- ou nano- fil sans nécessiter de former une autre zone de la couche tampon.

Dans l'étape de formation de la couche tampon, la couche tampon peut présenter sur son épaisseur au moins une deuxième zone comprenant la surface de la zone tampon qui est opposée à la première face du substrat, ladite seconde zone étant principalement composée de nitrure semiconducteur à gap direct autre qu'un nitrure de magnésium et présentant préférentiellement une composition sensiblement identique à la partie de contact du micro- ou nano- fil.

Une telle deuxième zone, en comprenant la surface de la zone tampon permet de fournir une surface de croissance présentant une bonne concordance de maille avec le matériau composant la partie de contact du micro- ou nano- fil limitant ainsi les risques de création de défauts cristallins dans le micro ou nano- fil lors de l'étape de formation de ce dernier. Cette même deuxième zone présente également une conductivité du même type que celle du micro- ou nano- fil avec une concentration en porteurs majoritaires qui est sensiblement identique, limitant ainsi la résistance d'interface entre ladite zone et le micro- ou nano- fil.

L'étape de formation de la couche tampon peut être une étape de formation d'une couche dont l'épaisseur est comprise entre 1 et 100 nm, l'épaisseur étant préférentiellement comprise entre 2 et 10 nm.

Une telle épaisseur de la couche tampon permet d'assurer une bonne adaptation de maille par rapport au substrat semi-conducteur. Cette même épaisseur permet également de limiter les risques de contamination du substrat pour des procédés de fabrication de micro - ou nano- fils mettant en oeuvre une étape de croissance telle que l'épitaxie en phase vapeur aux organométalliques (plus connue sous le sigle anglais MOVPE pour Metalorganic vapour phase epitaxy).

Dans l'étape de formation de la couche tampon, la première zone peut être principalement composée de nitrure de magnésium sous sa forme Mg₃N₂, préférentiellement monocristalline.

Une telle composition en magnésium et en azote permet de fournir une couche tampon de bonne qualité cristalline pour la croissance des micro- ou nano- fils. De plus cette qualité de la couche tampon permet la fourniture de micro- ou nano- fils présentant un type et une concentration en porteur majoritaire adéquats. De même, une couche tampon monocristalline offre une croissance de micro- ou nano- fil selon une même direction directement liée aux plans cristallins de la couche tampon.

L'étape de formation de la couche tampon peut être une étape de formation d'une couche présentant une conductivité dont les porteurs majoritaires sont des électrons, le nitrure semiconducteur formant au moins la partie de contact présentant un même type de conductivité que la couche tampon.

Lors de l'étape de formation d'au moins un micro- ou nano- fil le nitrure semiconducteur formant au moins la partie de contact peut être choisi dans le groupe comportant, le nitrure de gallium (GaN), le nitrure d'aluminium (AIN), le nitrure d'indium (InN), les nitrures de indium-gallium du type InₓGa₁₋ₓN, avec x compris entre 0 et 1 et les nitrures d'alluminium-gallium du type AlₓIn_{y}Ga_{1-x-y}N, avec x+y compris entre 0 et 1.

Ces nitrures semiconducteurs permettent de fournir des micro- ou nano- fils adaptés pour la détection, la mesure ou l'émission de rayonnements électromagnétiques dans des plages allant des ultra-violets aux infra-rouges lointains.

L'étape de formation d'au moins un micro- ou nano- fil semiconducteur peut comprendre les sous-étapes consistant à :
- déposer une couche dite de masquage sur la couche tampon, le matériau formant la couche de masquage étant adapté pour autoriser une croissance sélective du nitrure semiconducteur sur la couche tampon sans dépôt sur la couche de masquage lors d'un dépôt épitaxial adapté du nitrure semiconducteur,
- former dans la couche de masquage au moins une ouverture débouchant sur la couche tampon,
- former par un dépôt épitaxial sélectif un micro- ou nano- fil dans chaque ouverture.

Une telle étape de formation d'au moins un micro- ou un nano- film permet une croissance qui est sélective et parfaitement contrôlée avec la possibilité de contrôler l'emplacement du ou de chaque micro ou nano- fil par rapport au substrat et à d'autres structures ménagées dans ce même substrat.

L'invention concerne également une structure semiconductrice destinée à émettre un rayonnement électromagnétique comprenant :
- un substrat semiconducteur comportant une première et une seconde face,
- une couche tampon cristalline en contact de la première face,
- au moins un micro- ou nano- fil semiconducteur en contact avec la couche tampon, au moins une partie, dite de contact, dudit micro- ou nano- fil étant en nitrure semiconducteur à gap direct, ladite partie de contact étant la partie du micro- ou nano- fil en contact avec la couche tampon, le micro ou nano- fil présentant en outre une zone active adaptée pour émettre un rayonnement électromagnétique lorsqu'elle est polarisée,
- des moyens de connexion électrique du micro- ou nano- fil adaptés pour polariser le micro- ou nano- fil et sa zone active,
la couche tampon présentant sur au moins une partie de son épaisseur une première zone en contact avec la seconde face du substrat, la première zone étant principalement composée de nitrure de magnésium sous la forme MgₓN_{y}.

Ainsi, une telle structure peut présenter, en raison de la bonne caractéristique cristalline de chacun des micro- ou nano- fils, un bon rendement émissif tout en présentant une tension de fonctionnement qui est réduite par rapport à une structure de l'art antérieur, puisque la résistance électrique entre chacun des micro- ou nano- fils et le substrat est faible.

L'invention concerne également une structure semiconductrice apte à recevoir un rayonnement électromagnétique et à le convertir en un signal électrique, ladite structure comprenant :
- un substrat semiconducteur comportant une première et une seconde face,
- une couche tampon cristalline en contact de la première face,
- au moins un micro- ou nano- fil semiconducteur en contact avec la couche tampon, au moins une partie, dite de contact, dudit micro- ou nano- fil étant en nitrure semiconducteur à gap direct, ladite partie de contact étant la partie du micro- ou nano- fil en contact avec la couche tampon, le micro- ou nano- fil présentant en outre une zone active adaptée pour recevoir un rayonnement électromagnétique et le convertir en un signal électrique ,
- des moyens de connexion électrique adaptés pour autoriser la connexion électrique du micro- ou nano- fil de manière à récupérer le signal électrique,
la couche tampon présentant sur au moins une partie de son épaisseur une première zone en contact avec la seconde face du substrat, la première zone étant principalement composée de nitrure de magnésium sous la forme MgₓN_{y}.

Ainsi, une telle structure peut présenter, en raison de la bonne caractéristique cristalline de chacun des micro- ou nano- fils, un bon rendement de photogénération de porteur, pour la détection et ou la mesure de rayonnement électromagnétique avec des pertes liées à la résistance électrique entre le substrat et chacun des micro- ou nano- fils qui sont réduite vis-à-vis d'une structure de l'art antérieur.

L'invention concerne également un procédé de fabrication d'une structure opto-électrique selon l'invention, ledit procédé de fabrication comportant les étapes consistant à :
- former au moins un micro- ou nano- fil selon un procédé de fabrication de micro- ou nano- fil selon l'invention,
- former des moyens de connexion électrique du micro- ou nano- fil.

Un tel procédé permet de fournir des structures opto-électriques qui présentent à la fois un bon rendement, puisque comportant des micro- ou nano- fils de bonne qualité cristalline, et une tension de fonctionnement réduite, la résistance d'interface entre le substrat et les micro- ou nano- fils étant réduites de par la présence de la première zone principalement composée de nitrure semiconducteur.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre une structure semiconductrice selon un premier mode de réalisation de l'invention,
- les figures 2A à 2F illustrent les différentes étapes de fabrication de la structure semiconductrice illustrée sur la figure 1,
- les figures 3A à 3F illustrent les différentes étapes de fabrication d'une structure semiconductrice selon un deuxième mode de réalisation,
- la figure 4 illustre des micro- fils selon une possibilité de l'invention,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

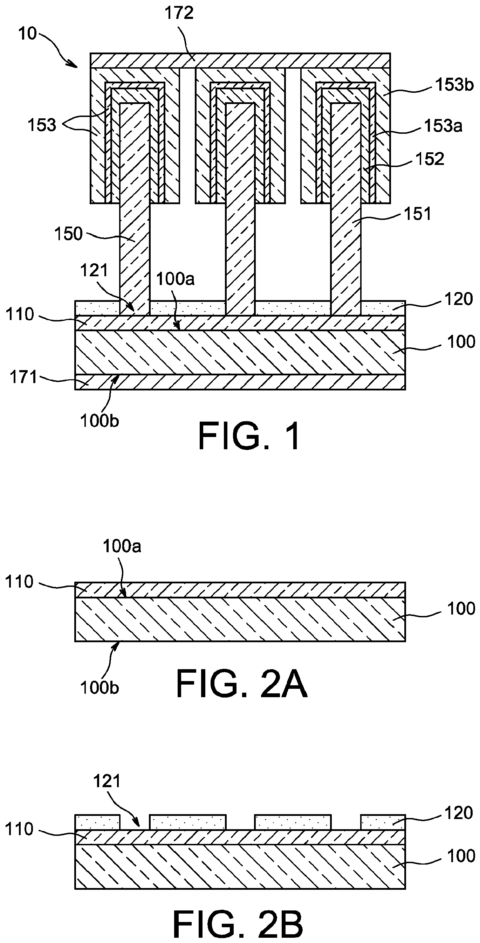

La figure 1 illustre schématiquement une structure semiconductrice 10 selon un premier mode de réalisation de l'invention qui est adaptée pour émettre un rayonnement électromagnétique.

Une telle structure 10 semiconductrice comporte :
- une première électrode 171 de polarisation,
- un substrat 100 semiconducteur comportant une première et une seconde face 100a, b, la seconde face étant en contact avec la première électrode de polarisation 171,
- une couche 110 dite tampon en contact avec la première face 100a du substrat 100,
- une couche de masquage 120 en contact avec la couche tampon 110, la couche de masquage 120 présentant trois ouvertures 121,
- trois micro- ou nano- fils 150 semiconducteurs chacun en contact avec la couche tampon 110 au travers de l'une des ouvertures 121, chacun des micro- ou nano- fils 150 comportant une partie 151, dite de contact, en contact avec la couche tampon 110, une zone active 152 en contact avec la partie de contact 151 et une partie 153, dite de polarisation en contact avec la zone active 152,
- une électrode 172 de polarisation en contact avec chacun des micro- ou nano- fils 150 au niveau de la partie de polarisation 153.

On entend ci-dessus et dans l'ensemble de ce documents par nano- ou micro- fils semiconducteurs des structures semiconductrices présentant trois dimensions, dont deux sont du même ordre de grandeur comprises entre 5 nm et 2,5 µm, la troisième dimension étant au moins égale à 10 fois la plus grande des deux autres dimensions.

Le substrat 100 est un substrat semiconducteur, tel qu'un substrat en silicium, en carbure de silicium, en saphir ou en germanium. Le substrat 100 présente une forme sensiblement plane.

Le substrat 100 présente un premier type de conductivité. Pour limiter les pertes électriques liées à la résistance électrique entre le substrat 100 et les micro- ou nano- fils 150, le substrat 100 présente une forte concentration de porteurs majoritaires.

Ainsi selon le mode de réalisation illustré sur la figure 1, le substrat 100 étant un substrat silicium dont le type de conductivité présente des porteurs majoritaires qui sont des électrons, la concentration en porteurs majoritaires peut être choisie comme étant de l'ordre de 10¹⁹ cm⁻³.

Le substrat 100 est en contact sur sa deuxième face 100b avec la première électrode 171 métallique.

La première électrode 171 prend la forme d'une couche conductrice qui s'étend sur la seconde face 100b du substrat 100. La première électrode 171 est constituée d'un matériau conducteur adapté au type de conductivité du substrat 100 de manière à créer un contact ohmique entre le substrat 100 et la première électrode 171. Pour le mode de réalisation illustré sur la figure 1, le substrat 100 étant en silicium dont les porteurs majoritaires sont des électrons, le matériau formant la première électrode 100 peut être, par exemple, un siliciure de nickel NiSi, de l'aluminium Al ou du titane Ti.

Le substrat 100 est en contact avec la couche tampon 110 sur sa première face 100a.

La couche tampon 110 est une couche semiconductrice qui s'étend sur la première face 100a du substrat 100. La couche tampon 110 est principalement composée de nitrure de magnésium sous sa forme MgₓN_{y}, c'est-à-dire qu'elle est composée d'au moins 95% de nitrure de magnésium. La couche tampon 110 est une couche cristalline et préférentiellement monocristalline. La couche tampon 110 présente une épaisseur de comprise entre 1 et 100 nm et est préférentiellement comprise entre 1 et 10 nm.

Selon une possibilité préférée de l'invention, la couche tampon 110 est composée principalement de nitrure de magnésium selon sa forme Mg₃N₂.

La couche tampon 110 présente le premier type de conductivité afin de limiter la résistance d'interface entre la couche tampon 110 et le substrat 100. Dans ce premier mode de réalisation, le premier type de conductivité étant du type dont les porteurs majoritaires sont des électrons, la proportion relative en azote est en sur-stoechiométrie de manière à ce que la couche tampon présente une concentration en porteurs majoritaires au moins égale à 1.10¹⁸ cm⁻³.

La couche tampon 110 présente, pour sa face qui est opposée au substrat 100, une polarité azote (N).

Cela permet d'obtenir une croissance de micro- ou nano- fils de semiconducteurs nitrurés, par exemple du nitrure de gallium. Les fils sont une structure verticale comportant une partie verticale suivant le plan cristallographique m. Cette partie verticale peut être la partie en contact avec la couche tampon 110.

La couche de masquage 120 s'étend à la surface de la couche tampon 110 qui est opposée au substrat 100. La couche de masquage 120 est réalisée dans un matériau sur lequel le ou les éléments composants les micro- ou nano- fils 150 ne se déposent pas lors d'un dépôt épitaxial. Le matériau formant la couche de masquage 120 peut être, pour des micro- ou -nano fils 150 en l'arséniure de gallium (GaAs), du nitrure de silicium (SiN), du titane (Ti), du nitrure de titane (TiN) ou encore de dioxyde de silicium (SiO₂). L'épaisseur de la couche de masquage 120 peut être comprise entre 1 et 50 nm

La couche de masquage 120 comporte trois ouvertures 121 traversantes, chacune de ces ouvertures 121 débouchant sur la surface de la couche tampon 110. Les ouvertures 121 présentent une forme sensiblement circulaire dont le diamètre est choisi en fonction du diamètre des micro- ou nano- fils 150.

Chacune des ouvertures 121 accueille un micro- ou nano- fil 150.

Chacun des micro- ou nano- fils 150 est une structure semiconductrice allongée dans la direction sensiblement perpendiculaire à la surface de la couche tampon 110. Chaque micro- ou nano- fil 150 présente une forme générale cylindrique allongée. Le diamètre de chacun des micro- ou nano- fils 150 est choisi en fonction de l'application de la structure 10 semiconductrice les comportant. Par exemple, dans le mode de réalisation illustré sur la figure 1, le diamètre de chaque micro- ou nano- fil 150 est compris entre 100 nm et 5 µm.

La hauteur de chacun des micro- ou nano- fil 150 est supérieure à au moins 10 fois le diamètre du micro- ou nano- fil 150 et est comprise entre 1 et 50 µm.

Chaque micro- ou nano- fil 150 comporte une partie de contact 151 en contact avec la surface de la couche tampon 110.

Chaque partie de contact 151, comme illustré sur la figure 1, représente la majeure partie du micro- ou nano- fil 150 correspondant. Chacune des parties de contact 151 est principalement constituée de nitrure semiconducteur à gap direct dont la conductivité est du premier type de conductivité. Le nitrure semiconducteur dans lequel sont réalisées les parties de contact 151 est adapté en fonction de l'application de la structure 10 semiconductrice comportant les micro- ou nano- fils 150.

Ainsi dans le mode de réalisation illustré sur la figure 1, chaque partie de contact 151 est en nitrure de gallium (GaN) et présente une concentration en porteurs majoritaires qui est comprise entre 1.10¹⁸ et 5.10¹⁸ cm⁻³. En fonction des applications visées, le matériau composant chacune des parties de contact 151 peut être sélectionné dans le groupe comportant, le nitrure de gallium (GaN), le nitrure d'aluminium (AIN), le nitrure d'indium (InN), les nitrures d'indium-gallium du type InₓGa₁₋ₓN, avec x compris entre 0 et 1 et les nitrures d'alluminium-gallium du type AlₓIn_{y}Ga_{1-x-y}N, avec x+y compris entre 0 et 1..

Chacune des zones actives 152 est en contact avec la partie de contact 151 du micro- ou du nano- fil 150 correspondant. Chaque zone active 152 est une couche recouvrant la partie de contact 151 sur une partie du pourtour et sur l'extrémité de la partie de contact 151 correspondante, ladite extrémité de la partie de contact 151 étant celle qui est opposée à la couche tampon 110. Une telle configuration des zones actives 152 dans laquelle elles sont en contact avec à la fois avec une extrémité et le pourtour de la partie de contact 151 correspondante est dite coquille.

Les zones actives 152 sont au moins partiellement réalisées dans un nitrure semiconducteur à gap direct présentant un deuxième type de conductivité opposé au premier type de conductivité.

Ainsi chaque zone active 152 forme une jonction semiconductrice avec la partie de contact 151 correspondante. La zone active 152 peut, afin d'augmenter le rendement d'émission de chacun des micro- ou nano- fils, comporter des moyens de confinement, tels que des puits quantiques multiples.

Dans le mode de réalisation illustré sur la figure 1, la zone active 152 est constituée de nitrure de gallium et d'indium sous la forme InₓGa₁₋ₓN. Selon ce mode de réalisation les puits quantiques multiples sont obtenus en alternant sur l'épaisseur de la zone active 152 deux compositions relatives différentes d'indium In et de gallium Ga. Dans ce même mode de réalisation, la concentration en porteurs majoritaires de chaque zone active 152 est comprise entre 1.10¹⁶ et 1.10¹⁸ cm⁻³ et peut être variée le long de son épaisseur.

Les zones actives 152 en tant que telles étant bien connues de l'homme du métier, elles ne sont pas décrites plus en détail dans ce document.

Chaque zone actives 152 est en contact sur son pourtour extérieur avec la partie de polarisation 153 du micro- ou nano- fil correspondant.

Les partie de polarisation 153 permettent à la fois de contacter le micro- ou nano- fil 150 correspondant et font également fonction, dans le cas ou la structure 10 est une structure adaptée pour l'émission d'un rayonnement électromagnétique, de couche de blocage d'électrons.

En effet, une telle fonction de couche de blocage d'électrons permet de localiser les recombinaisons électron-trou dans la zone active 152 ceci afin d'augmenter le rendement émissif de chacun des micro- ou nano- fils 150.

Les parties de polarisation 153 sont préférentiellement composées principalement de nitrure semiconducteur à gap direct. Chacune des parties de polarisation 153 présente une conductivité du deuxième type. Les parties de polarisation 153 présentent chacune une concentration en porteurs majoritaires qui est comprise entre 1.10¹⁷ et 1.10¹⁸cm^{-3.}

Dans le mode de réalisation illustré sur la figure 1, les parties de polarisation 153, faisant également fonction de couche de blocage d'électrons, elles comportent une première zone 153a en nitrure de gallium et aluminium (AIGaN), en contact avec la zone active 152.

Selon ce même mode de réalisation, chaque partie de polarisation 153 comporte également, pour assurer un bon contact électrique entre la deuxième électrode 172 et la zone active, une deuxième zone 153b en nitrure de gallium (GaN) en contact avec la première zone 153a de la partie de polarisation 153.

Chaque partie de polarisation 153, pour permettre la polarisation de chacun des micro- ou nano- fils 150, est en contact par sa deuxième zone 153b avec la deuxième électrode 172.

La deuxième électrode 172 est adaptée pour à la fois autoriser une polarisation de chacun des micro- ou nano- fils 150 au niveau de leur partie de polarisation 153 et laisser passer le rayonnement électromagnétique émis ou reçu par les micro- ou nano- fils 153.

Ces deux fonctions peuvent être obtenues au moyen d'une deuxième électrode former de deux étages différents, non illustrés, un premier étage formé par une couche conductrice de faible épaisseur au moins partiellement transparente pour contacter l'ensemble des parties de polarisation des micro- ou nano- fils et un deuxième étage de distribution, qui ne recouvre qu'une faible partie de la surface de la couche conductrice en prenant la forme, par exemple, d'un peigne. Le deuxième étage de distribution comporte une plus grande épaisseur que celle de la couche conductrice formant le premier étage pour réduire la résistance série.

Selon cette configuration, le premier étage peut être formé d'une couche de nickel-or (Ni-Au) ou d'oxyde d'indium-étain (ITO). Le deuxième étage, selon cette même configuration, peut être formé par un peigne en nickel-or.

La deuxième électrode avec la première électrode forme des moyens de connexion des micro- ou nano- fils 150 adaptés pour polariser chacun des micro- ou nano- fils 150 et leur zone active 153.

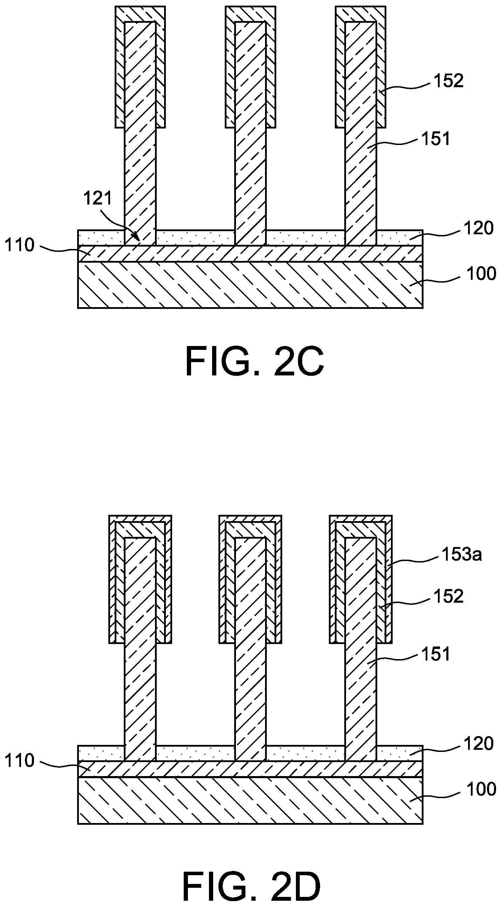

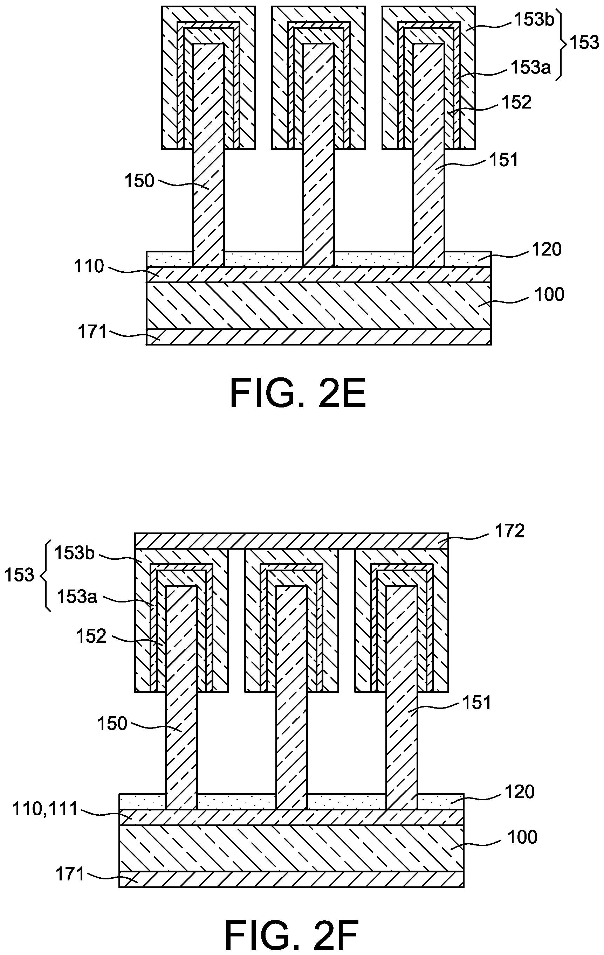

Une telle structure 10 semiconductrice peut être obtenue au moyen d'un procédé de fabrication tel qu'illustré sur les figures 2A à 2F.

Un procédé de fabrication d'une structure 10 semiconductrice selon le premier mode de réalisation comporte les étapes consistant à :
- fournir le substrat 100 semiconducteur,
- former la première électrode 171, non illustrée sur les figures 2A à 2F, sur la deuxième face du substrat 100,
- former la couche tampon 110, comme illustré sur la figure 2A, la couche tampon 110 étant composée principalement de nitrure de magnésium sous sa forme MgₓN_{y}, ladite couche étant cristalline
- déposer la couche de masquage 120,
- former, comme illustré sur la figure 2B, les ouvertures 121 traversant dans la couche de masquage 120, cette formation des ouvertures 121 pouvant être obtenue par la combinaison d'une sous étape de lithographie et d'une sous étape de gravure,
- former, comme illustré sur les figures 2C à 2E, les micro- ou nano- fils 150 dans les ouvertures 121,
- former, comme illustré sur la figure 2F, la deuxième électrode 172 en contact avec chacune des parties de polarisation 153 des micro- ou nano-fils 150.

L'étape de formation de la couche tampon 110 est réalisée au moyens d'au moins une sous-étape de dépôt épitaxial selon un procédé de dépôt, tel que l'épitaxie en phase vapeur aux organométalliques, l'épitaxie par jet moléculaire, l'épitaxie hybride en phase vapeur ou encore la pulvérisation cathodique réactive.

Le procédé de dépôt de la couche tampon 110 est choisi en fonction de la stoechiométrie recherchée pour la couche tampon 110. Ainsi pour la stoechiométrie du type Mg₃N₂, la procédé de dépôt peut être choisi parmi les procédés de dépôt que sont l'épitaxie en phase vapeur aux organométalliques, l'épitaxie par jet moléculaire, l'épitaxie hybride en phase vapeur. Pour une stoechiométrie du type MgₓN_{y}, ce sont les procédés de dépôt utilisant une cible solide de magnésium qui sont mis en oeuvre, tel que la pulvérisation cathodique réactive et l'ablation laser réactive.

L'étape de formation des micro- ou nano- fils 150 peut être réalisée par des sous-étapes de dépôt épitaxial de manière à former successivement pour chacun des micro- ou nano- fils, la partie de contact 151, la zone active 152, la partie de polarisation 153.

Ces sous étapes de dépôt épitaxial peuvent mettre en oeuvre des procédés de dépôt tels que l'épitaxie en phase vapeur aux organométalliques, l'épitaxie par jet moléculaire, l'épitaxie hybride en phase vapeur. Ces sous-étapes étant des sous-étapes connues de l'homme du métier, elles ne sont donc pas explicitées plus en détail dans ce document.

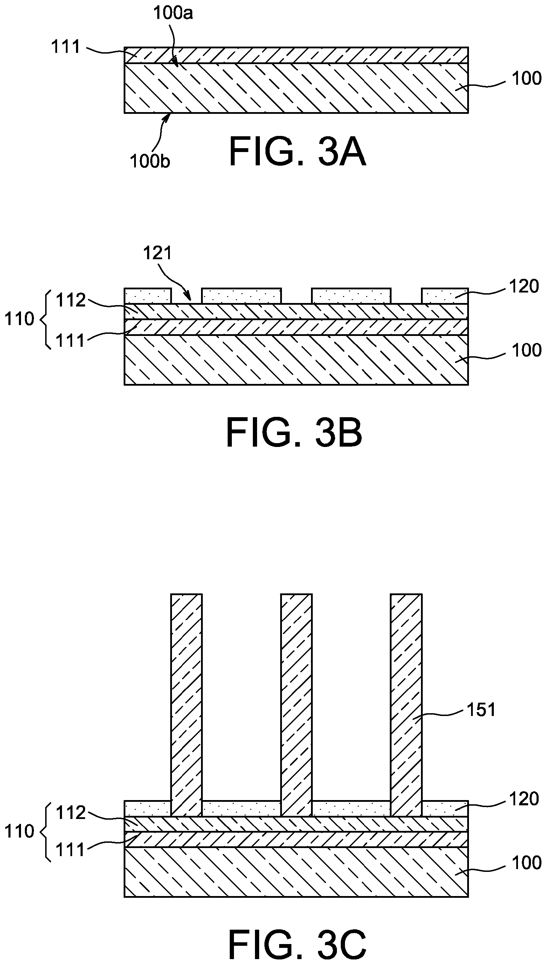

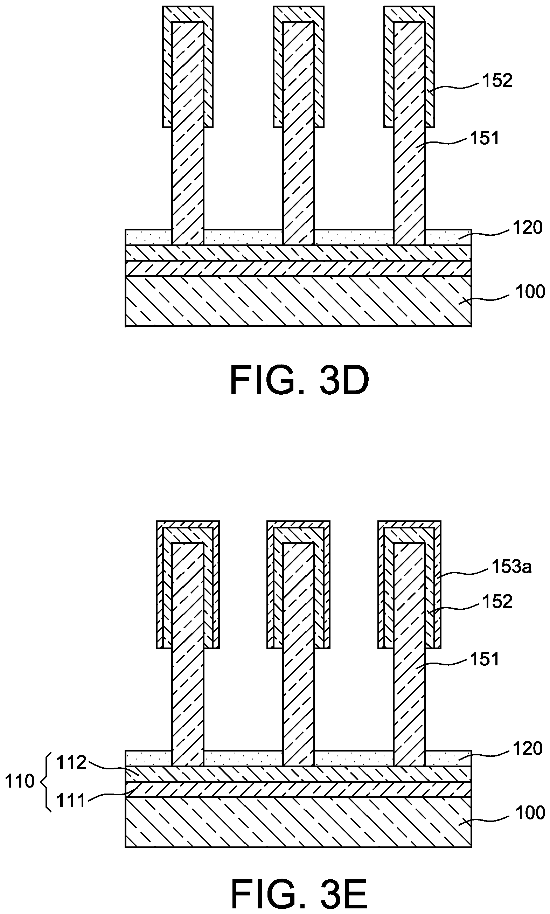

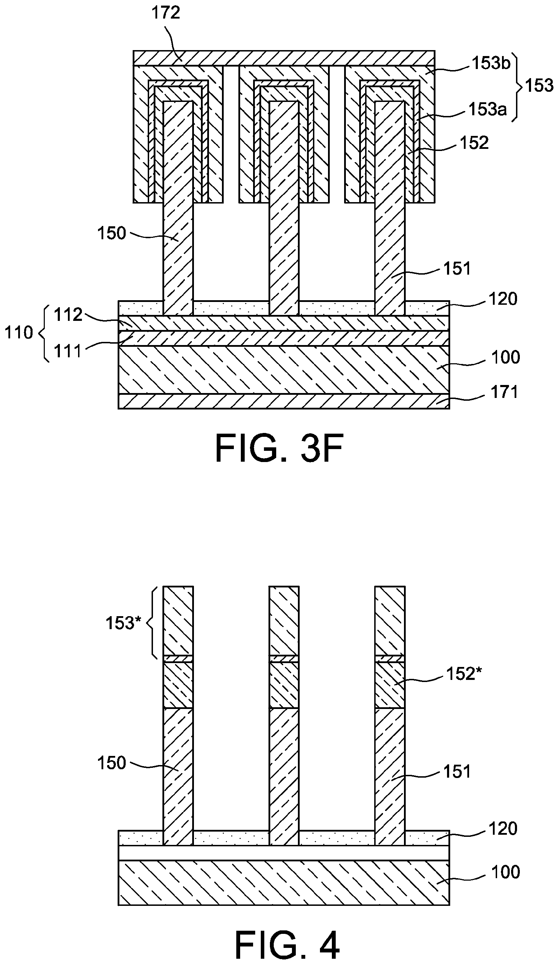

Les figures 3A à 3F illustrent un procédé de formation d'une structure 10 semiconductrice selon un deuxième mode de réalisation de l'invention. Une telle structure se différencie d'une structure selon le premier mode de réalisation de l'invention en ce que la couche tampon 110 comprend une deuxième zone 112 principalement composée de nitrure semiconducteur, ladite deuxième zone 112 comprenant la surface de la couche tampon 110 qui est opposée à la première face 100a du substrat 100.

La couche tampon 110 selon ce deuxième mode de réalisation comporte successivement le long de son épaisseur une première zone 111 en contact avec la seconde face 100a du substrat 100 et une deuxième zone 112 comprenant la surface de la couche tampon 110.

La première zone 111 de la couche tampon 110 présente les mêmes caractéristiques qu'une couche tampon 110 selon le premier mode de réalisation.

La deuxième zone 112 de la couche tampon 110 est principalement composée dans un nitrure semiconducteur du premier type de conductivité. Cette deuxième zone de la couche tampon 110 présente, préférentiellement, et afin d'optimiser la croissance des micro- et nano- fils 150 lors l'étape de formation de ces derniers, une composition sensiblement identique à celle de la partie de contact 151 des micro- ou nano- fils 150. La deuxième zone 112 de la couche tampon 110 présente une épaisseur comprise entre 1 nm et 1 µm, qui est préférentiellement de l'ordre de 100 nm.

Le procédé de fabrication d'une structure 10 semiconductrice selon ce deuxième mode de réalisation se différencie d'un procédé de fabrication d'une structure semiconductrice selon le premier mode de réalisation en ce que l'étape de formation de la couche tampon 110, telle qu'elle est illustrée sur les figures 3A et 3B, comprend un changement du matériau déposer lors du dépôt de la couche tampon 110 ceci afin de former successivement la première et la deuxième zone 111, 112. Le reste des étapes du procédé de fabrication sont, comme illustré sur les figures 3C à 3F identiques à celles du procédé de fabrication d'une structure selon le premier mode de réalisation.

La figure 4 illustre une possibilité de l'invention selon laquelle les zones actives 152* des micro ou nano- fils ne sont pas des zones actives du type coquille mais des zones actives 152* du type axial. De telles zones actives 152* se différencient d'une zone active selon les deux modes de réalisation décrits ci-dessus en ce qu'elles sont dans le prolongement des parties de contact correspondantes et en ce que le contact entre lesdites zones actives 152* et les parties de contact 151 correspondantes est uniquement au niveau de l'extrémité de la partie de contact 151.

Selon cette même possibilité, chaque partie de polarisation 153* est également dans le prolongement de la partie de contact 151 et de la zone active 152* correspondantes, le contact entre chaque partie de polarisation 153* et la zone active 152* correspondante étant uniquement au niveau de l'extrémité de la zone active 152*.

Le procédé de fabrication d'une structure 10 semiconductrice selon cette possibilité se différencie du procédé de fabrication d'une structure 10 semiconductrice selon le premier mode de réalisation uniquement par l'étape de formation des micro- ou nano- fils 150 qui est adapté pour la formation de micro- ou nano- fils comportant une zone active du type axial.

Dans les différents modes de réalisation ou possibilités décrits ci-dessus, les micro- ou nano- fils 150 sont des micro- ou nano- fils obtenus par croissance sélective au moyen d'une couche de masquage 120 présentant des ouvertures 121. Il est néanmoins, possible, sans que l'on sorte du cadre de l'invention, que les micro- ou nano-fils 150 soient formés par croissance localisée par catalyseur ou par croissance auto-organisée.

Si les différents modes de réalisation ou possibilités décrits ci-dessus concernent des structures 10 semiconductrices adaptées pour émettre un rayonnement électromagnétique, de telles structures 10 semiconductrices peuvent aisément être adaptées par un homme du métier pour recevoir un rayonnement électromagnétique et le convertir en un signal électrique. Une telle adaptation est réalisée en adaptant à la fois la zone active 152 de chacun des micro- et nano- fils 150 et en appliquant sur la structure semiconductrice une polarisation adéquate. Une telle adaptation de la structure 10 semiconductrice peut être réalisée pour former soit une structure 10 semiconductrice dédiée à la mesure ou la détection d'un rayonnement électromagnétique ou soit une structure 10 semiconductrice dédiée aux applications photovoltaïques. De telles adaptations peuvent être réalisées sans que l'on sorte du cadre de l'invention.

Si dans les différents modes de réalisation et possibilités décrits ci-dessus, les porteurs majoritaires du premier type de conductivité sont des électrons, il est possible, ceci sans que l'on sorte du cadre de l'invention, que les porteurs majoritaires du premier type de conductivité soient des trous, les porteurs majoritaires du deuxième type de conductivité étant alors des électrons.

## Revendications

1. Procédé de fabrication d'au moins un micro- ou nano- fil (150) semiconducteur destiné à la formation d'une structure (10) opto-électrique, ledit procédé comporte les étapes consistant à :
- fournir un substrat (100) semiconducteur comportant une première et une seconde face (100a,b),
- former une couche (110) cristalline, dite tampon, sur la première face (100a) du substrat (100), la couche tampon (110) présentant sur au moins une partie de son épaisseur une première zone (110, 111) en contact avec la seconde face (100a),
- former au moins un micro- ou nano- fil (150) semiconducteur sur la couche tampon (110), au moins une partie (151) dudit micro- ou nano- fil (150), dite de contact, étant principalement constituée de nitrure semiconducteur à gap direct, ladite partie (151) étant la partie du micro- ou nano- fil (150) en contact avec la couche tampon (110),
ledit procédé étant **caractérisé en ce que** la première zone (110, 111) est principalement composée de nitrure de magnésium sous la forme MgₓN_{y}.

2. Procédé de fabrication selon la revendication 1, dans lequel la partie de contact (151) du micro- ou nano-fil (150) est constitué de nitrure de gallium.

3. Procédé de fabrication selon la revendication 1 ou 2, dans lequel dans l'étape de formation de la couche tampon (110), la couche tampon (110) est principalement composée de nitrure de magnésium sous la forme MgₓN_{y}.

4. Procédé de fabrication selon la revendication 1 ou 2, dans lequel dans l'étape de formation de la couche tampon (110), la couche tampon (110) présente sur son épaisseur au moins une deuxième zone (112) comprenant la surface de la zone tampon (110) qui est opposée à la première face (100a) du substrat (100), ladite seconde zone (112) étant principalement composée de nitrure semiconducteur à gap direct autre qu'un nitrure de magnésium et présentant préférentiellement une composition sensiblement identique à la partie de contact (151) du micro- ou nano- fil (150).

5. Procédé de fabrication selon l'une quelconque des précédentes revendications, dans lequel l'étape de formation de la couche tampon (110) est une étape de formation d'une couche dont l'épaisseur est comprise entre 1 et 100 nm, l'épaisseur étant préférentiellement comprise entre 2 et 10 nm.

6. Procédé de fabrication selon l'une quelconque des revendications précédentes, dans lequel, dans l'étape de formation de la couche tampon (110), la première zone (110, 111) est principalement composée de nitrure de magnésium sous sa forme Mg₃N₂, préférentiellement monocristalline.

7. Procédé de fabrication selon l'une quelconque des revendications précédentes, dans lequel l'étape de formation de la couche tampon (110) est une étape de formation d'une couche présentant une conductivité dont les porteurs majoritaires sont des électrons, le nitrure semiconducteur formant au moins la partie de contact (151) présentant le même type de conductivité que la couche tampon (110).

8. Procédé de fabrication selon l'une quelconque des revendications précédentes, dans lequel lors de l'étape de formation d'au moins un micro- ou nano- fil (150), le nitrure semiconducteur à gap direct formant au moins la partie de contact (151) est choisi dans le groupe comportant, le nitrure de gallium (GaN), le nitrure d'aluminium (AIN), le nitrure d'indium (InN), les nitrures de indium-gallium du type InₓGa₁₋ₓN avec x compris entre 0 et 1 et les nitrures d'alluminium-gallium du type AlₓIn_{y}Ga_{1-x-y}N, avec x+y compris entre 0 et 1.

9. Procédé de fabrication selon l'une quelconque des revendications précédente, dans lequel l'étape de formation d'au moins un micro- ou nano- fil (150) semiconducteur comprend les sous-étapes consistant à :
- déposer une couche (120) dite de masquage sur la couche tampon (110), le matériau formant la couche de masquage (120) étant adapté pour autoriser une croissance sélective du nitrure semiconducteur sur la couche tampon (110) sans dépôt sur la couche de masquage lors d'un dépôt épitaxial adapté du nitrure semiconducteur,
- former dans la couche de masquage (120) au moins une ouverture (121) débouchant sur la couche tampon (110),
- former par un dépôt épitaxial sélectif un micro- ou nano- fil (150) dans chaque ouverture (121).

10. Structure (10) semiconductrice destinée à émettre un rayonnement électromagnétique comprenant :
- un substrat (100) semiconducteur comportant une première et une seconde face (100a,b),
- une couche tampon (110) cristalline en contact de la première face (100a), la couche tampon (110) présente sur au moins une partie de son épaisseur une première zone (110, 111) en contact avec la seconde face (100a) du substrat (100),
- au moins un micro- ou nano- fil (150) semiconducteur en contact avec la couche tampon (110), au moins une partie (151), dite de contact, dudit micro- ou nano- fil (150) étant principalement constituée de nitrure semiconducteur à gap direct, ladite partie de contact (151) étant la partie du micro- ou nano- fil en contact avec la couche tampon (110), le micro- ou nano- fil (150) présentant en outre une zone active (152) adaptée pour émettre un rayonnement électromagnétique lorsqu'elle est polarisée,
- des moyens de connexion électrique du micro- ou nano- fil (150) adaptés pour polariser le micro- ou nano- fil (150) et sa zone active,
la structure (10) **étant caractérisée en ce que** la première zone (110, 111) est principalement composée de nitrure de magnésium sous la forme MgₓN_{y}.

11. Structure (10) semiconductrice apte à recevoir un rayonnement électromagnétique et à le convertir en un signal électrique, ladite structure (10) comprenant :
- un substrat (100) semiconducteur comportant une première et une seconde face (100a,b),
- une couche tampon (110) cristalline en contact de la première face (100a), la couche tampon (110) présente sur au moins une partie de son épaisseur une première zone (110, 111) en contact avec la seconde face (100a) du substrat (100),
- au moins un micro- ou nano- fil semiconducteur (150) en contact avec la couche tampon (110), au moins une partie (151), dite de contact, dudit micro- ou nano- fil (150) étant principalement constituée de nitrure semiconducteur à gap direct, ladite partie de contact (151) étant la partie du micro- ou nano- fil (150) en contact avec la couche tampon (110), le micro- ou nano- fil (150) présentant en outre une zone active (152) adaptée pour recevoir un rayonnement électromagnétique et le convertir en un signal électrique ,
- des moyens de connexion électrique adaptés pour autoriser la connexion électrique du micro- ou nano- fil (150) de manière à récupérer le signal électrique,
la structure **étant caractérisée en ce que** la première zone (110, 111) est principalement composée de nitrure de magnésium sous la forme MgₓN_{y}.

12. Procédé de fabrication d'une structure (10) opto-électrique dans lequel la structure (10) est une structure selon la revendication 10 ou 11, ledit procédé de fabrication comportant les étapes consistant à :
- former au moins un micro- ou nano- fil (150) selon un procédé de fabrication de micro- ou nano- fil (150) selon l'une quelconque des revendications 1 à 8,
- former des moyens de connexion électrique du micro- ou nano- fil (150).

## Patentansprüche

1. Verfahren zum Herstellen zumindest eines Halbleitermikro- oder -Nanodrahts (150) zum Bilden einer optoelektrischen Struktur (10), wobei das Verfahren die nachfolgenden Schritte umfasst:
- Bereitstellen eines Halbleitersubstrats (100) mit einer ersten und einer zweiten Seite (100a, b),
- Ausbilden einer kristallinen Schicht (110), Pufferschicht genannt, auf der ersten Seite (100a) des Substrats (100), wobei die Pufferschicht (110) über zumindest einen Teil ihrer Dicke einen ersten Bereich (110, 111) in Kontakt mit der zweiten Seite (100a) aufweist,
- Ausbilden zumindest eines Halbleitermikro- oder -Nanodrahts (150) auf der Pufferschicht (110), wobei zumindest ein Teil (151) des Mikro- oder Nanodrahts (150), Kontaktteil genannt, im Wesentlichen aus Halbleiternitrid mit direkter Bandlücke besteht, wobei der Teil (151) ein Teil des Mikro- oder Nanodrahts (150) in Kontakt mit der Pufferschicht (110) ist,
wobei das Verfahren **dadurch gekennzeichnet ist, dass** der erste Bereich (110, 111) im Wesentlichen aus Magnesiumnitrid in der Form MgₓN_{y} besteht.

2. Herstellungsverfahren nach Anspruch 1, wobei der Kontaktteil (151) des Mikro- oder Nanodrahts (150) aus Galliumnitrid besteht.

3. Herstellungsverfahren nach Anspruch 1 oder 2, wobei bei dem Schritt des Ausbildens der Pufferschicht (110) die Pufferschicht (110) im Wesentlichen aus Magnesiumnitrid in der Form MgₓN_{y} besteht.

4. Herstellungsverfahren nach Anspruch 1 oder 2, wobei bei dem Schritt des Ausbildens der Pufferschicht (110) die Pufferschicht (110) über ihre Dicke zumindest einen zweiten Bereich (112) aufweist, der die Fläche des Pufferbereichs (110) enthält, die der ersten Seite (100a) des Substrats (100) entgegengesetzt ist, wobei der zweite Bereich (112) im Wesentlichen aus einem anderen Halbleiternitrid mit direkter Bandlücke als ein Magnesiumnitrid besteht und vorzugsweise eine im Wesentlichen identische Zusammensetzung wie der Kontaktbereich (151) des Mikro- oder Nanodrahts (150) aufweist.

5. Herstellungsverfahren nach einem der vorangehenden Ansprüche, wobei der Schritt des Ausbildens der Pufferschicht (110) ein Schritt des Ausbildens einer Schicht ist, deren Dicke zwischen 1 und 100 nm beträgt, wobei die Dicke vorzugsweise zwischen 2 und 10 nm beträgt.

6. Herstellungsverfahren nach einem der vorangehenden Ansprüche, wobei bei dem Schritt des Ausbildens der Pufferschicht (110) der erste Bereich (110, 111) im Wesentlichen aus Magnesiumnitrid in seiner Form Mg₃N₂ besteht und vorzugweise monokristallin ist.

7. Herstellungsverfahren nach einem der vorangehenden Ansprüche, wobei der Schritt des Ausbildens der Pufferschicht (110) ein Schritt des Ausbildens einer Schicht ist, die eine Leitfähigkeit aufweist, deren Majoritätsträger Elektronen sind, wobei das Halbleiternitrid zumindest einen Kontaktteil (151) bildet, der den gleichen Typ von Leitfähigkeit wie die Pufferschicht (110) aufweist.

8. Herstellungsverfahren nach einem der vorangehenden Ansprüche, wobei bei dem Schritt des Bildens zumindest eines Mikro- oder Nanodrahts (150), das Halbleiternitrid mit direkter Bandlücke, das zumindest den Kontaktteil (151) bildet, ausgewählt ist aus der Gruppe umfassend Galliumnitrid (GaN), Aluminiumnitrid (AIN), Indiumnitrid (InN), Indium-Gallium-Nitride des Typs InₓGa₁₋ₓN mit x zwischen 0 und 1, und Aluminium-Gallium-Nitride des Typs AlₓIn_{y}Ga_{1-x-y}N, mit x + y zwischen 0 und 1.

9. Herstellungsverfahren nach einem der vorangehenden Ansprüche, wobei der Schritt des Bildens zumindest eines Halbleitermikro- oder -Nanodrahts (150) die nachfolgenden Unterschritte umfasst:
- Aufbringen einer Schicht (120), Maskierungsschicht genannt, auf die Pufferschicht (110), wobei das die Maskierungsschicht (120) bildende Material dazu geeignet ist, bei einem geeigneten epitaxialen Abscheiden von Halbleiternitrid ein selektives Wachsen von Halbleiternitrid auf der Pufferschicht (110) ohne Abscheidung auf die Maskierungsschicht zu gestatten,
- Ausbilden zumindest einer auf die Pufferschicht (110) ausmündenden Öffnung (121) in der Maskierungsschicht (120),
- Bilden eines Mikro- oder Nanodrahts (150) in jeder Öffnung (121) durch selektives, epitaxiales Abscheiden.

10. Halbleiterstruktur (10) zum Emittieren einer elektromagnetischen Strahlung, enthaltend:
- ein Halbleitersubstrat (100) mit einer ersten und einer zweiten Seite (100a, b),
- eine kristalline Pufferschicht (110) in Kontakt mit der ersten Seite (100a), wobei die Pufferschicht (110) über zumindest einen Teil ihrer Dicke einen ersten Bereich (110, 111) in Kontakt mit der zweiten Seite (100a) des Substrats (100) aufweist,
- zumindest einen Halbleitermikro- oder -Nanodraht (150) in Kontakt mit der Pufferschicht (110), wobei zumindest ein Teil (151) des Mikro- oder Nanodrahts (150), Kontaktteil genannt, im Wesentlichen aus Halbleiternitrid mit direkter Bandlücke besteht, wobei der Kontaktteil (151) der Teil des Mikro- oder Nanodrahts (150) in Kontakt mit der Pufferschicht (110) ist, wobei der Mikro- oder Nanodraht (150) ferner einen Wirkbereich (152) aufweist, der dazu geeignet ist, bei Polarisation eine elektromagnetische Strahlung zu emittieren,
- Mittel zum elektrischen Verbinden des Mikro- oder Nanodrahts (150), die dazu geeignet sind, den Mikro- oder Nanodraht (150) und seinen Wirkbereich zu polarisieren,
wobei die Struktur (10) **dadurch gekennzeichnet ist, dass** der erste Bereich (110, 111) im Wesentlichen aus Magnesiumnitrid in der Form MgₓN_{y} besteht.

11. Halbleiterstruktur (10) zum Empfangen einer elektromagnetischen Strahlung und zum Umwandeln in ein elektrisches Signal, wobei die Struktur (10) enthält:
- ein Halbleitersubstrat (100) mit einer ersten und einer zweiten Seite (100a, b),
- eine kristalline Pufferschicht (110) in Kontakt mit der ersten Seite (100a), wobei die Pufferschicht (110) über zumindest einen Teil ihrer Dicke einen ersten Bereich (110, 111) in Kontakt mit der zweiten Seite (100a) des Substrats (100) aufweist,
- zumindest einen Halbleitermikro- oder -Nanodraht (150) in Kontakt mit der Pufferschicht (110), wobei zumindest ein Teil (151) des Mikro- oder Nanodrahts (150), Kontaktteil genannt, im Wesentlichen aus Halbleiternitrid mit direkter Bandlücke besteht, wobei der Kontaktteil (151) der Teil des Mikro- oder Nanodrahts (150) in Kontakt mit der Pufferschicht (110) ist, wobei der Mikro- oder Nanodraht (150) ferner einen Wirkbereich (152) aufweist, der dazu geeignet ist, eine elektromagnetische Strahlung zu empfangen und sie in ein elektrisches Signal umzuwandeln,
- Mittel zum elektrischen Verbinden, die dazu geeignet sind, die elektrische Verbindung des Mikro- oder Nanodrahts (150) so zu gestatten, dass das elektrische Signal zurückerhalten wird,
wobei die Struktur **dadurch gekennzeichnet ist, dass** der erste Bereich (110, 111) im Wesentlichen aus Magnesiumnitrid in der Form MgₓN_{y} besteht.

12. Verfahren zum Herstellen einer optoelektrischen Struktur (10), wobei die Struktur (10) eine Struktur nach Anspruch 10 oder 11 ist, wobei das Herstellungsverfahren die nachfolgenden Schritte umfasst:
- Bilden zumindest eines Mikro- oder Nanodrahts (150) mit einem Verfahren zum Herstellen eines Mikro- oder Nanodrahts (150) nach einem der Ansprüche 1 bis 8,
- Ausbilden von Mitteln zum elektrischen Verbinden des Mikro- oder Nanodrahts (150).

## Claims

1. Manufacturing method of at least one semiconducting micro- or nano-wire used for the formation of an optoelectric structure (10), wherein the manufacturing method comprises steps to:
- provide a semiconducting substrate (100) comprising a first and a second face (100a, b);
- form a crystalline layer called the buffer layer, on the first face (100a) of the substrate (100), the buffer layer (110) having over at least part of its thickness a first zone (110, 111) in contact with the second face (100a;
- form at least one semiconducting micro- or nano-wire (150) on the buffer layer (110), at least one part (151) of said micro- or nano-wire (150), called the contact part, being composed mainly of direct band gap semiconducting nitride, said part (151) being the part of the micro- or nano-wire (150) in contact with the buffer layer (110),
said method being **characterized in that** the first zone (110, 111) is composed mainly of magnesium nitride in the form MgₓN_{y}.

2. Manufacturing method according to claim 1 in which, the contact part of the micro or nano-wire is constituted of gallium nitride.

3. Manufacturing method according to claim 1 or 2 in which, the buffer layer (110) formed in the formation step of the buffer layer is composed mainly of magnesium nitride in the form MgₓN_{y}.

4. Manufacturing method according to claim 1 or 2 in which, in the formation step of the buffer layer (110), the buffer layer (110) has at least one second zone (112) over its thickness comprising the surface of the buffer zone (110) that is opposite the first face (100a) of the substrate (100), said second zone (112) being composed mainly of a direct band gap semiconducting nitride other than a magnesium nitride and preferably with a composition practically the same as the contact part (151) of the micro- or nano-wire (150) .

5. Manufacturing method according to any one of the preceding claims, in which the formation step of the buffer layer (110) is a step to form a layer with a thickness of between 1 and 100 nm, the thickness preferably being between 2 and 10 nm.

6. Manufacturing method according to any one of the preceding claims, in which in the formation step of the buffer layer (110), the first zone is composed mainly of magnesium nitride in the form Mg₃N₂, preferably monocrystalline.

7. Manufacturing method according to any one of the preceding claims, in which the formation step of the buffer layer (110) is a step forming a layer with a conductivity for which the majority carriers are electrons, the semiconducting nitride forming at least the contact part (151) with the same type of conductivity as the buffer layer (110).

8. Manufacturing method according to any one of the preceding claims, in which during the formation step of at least one micro- or nano-wire (150), the direct band gap semiconducting nitride forming at least the contact part (151) is chosen from the group comprising gallium nitride (GaN), aluminium nitride (AlN), indium nitride (InN), indium-gallium nitrides type InₓGa₁₋ₓN where x is between 0 and 1, and the aluminium-gallium nitrides type AlₓIn_{y}Ga_{1-x-y}N, where x+y is between 0 and 1.

9. Manufacturing method according to any one of the preceding claims, in which the formation step of at least one semiconducting micro- or nano-wire (150) comprises sub-steps to:
- deposit a so-called masking layer (120) on the buffer layer (110), the material forming the masking layer (120) being adapted to enable selective growth of the semiconducting nitride on the buffer layer (110) without any deposition on the masking layer (120) during an adapted epitaxial deposition of the semiconducting nitride;
- form at least one opening (121) in the masking layer (120) leading to the buffer layer (110);
- form a micro or nano-wire (150) in each opening (121) by selective epitaxial deposition.

10. Semiconducting structure (10) designed to emit electromagnetic radiation, comprising:
- a semiconducting substrate (100) comprising a first and a second face (100a, b);
- a crystalline buffer layer (110) in contact with the first face (100a), the buffer layer (110) has over at least part of its thickness a first zone (110, 110) in contact with the second face (100b) of the substrate;
- at least one semiconducting micro- or nano-wire (150) in contact with the buffer layer (110), at least one so-called contact part (151), of said micro- or nano-wire (150) being composed mainly of a direct band gap semiconducting nitride, said contact part (151) being the part of the micro- or nano-wire (150) in contact with the buffer layer (110), the micro- or nano-wire (150) also having an active zone (152) adapted to emit electromagnetic radiation when it is polarised;
- means of making the electrical connection of the micro- or nano-wire (150) adapted to polarise the micro- or nano-wire (150) and its active zone (152);
the structure (10) being **characterized in that** the first zone (110, 111) is composed mainly of magnesium nitride in the form MgₓN_{y}.

11. Semiconducting structure (10) capable of receiving electromagnetic radiation and converting it into an electrical signal, said structure (10) comprising:
- a semiconducting substrate (100) comprising a first and a second face (100a, b);
- a crystalline buffer layer (110) in contact with the first face (100a), the buffer layer (110) has over at least part of its thickness a first zone in contact with the second face (100a) of the substrate (100);
- at least one semiconducting micro- or nano-wire (150) in contact with the buffer layer (110), at least one part called the contact part (151) of said micro- or nano-wire being composed mainly of a direct band gap semiconducting nitride, said contact part (151) being the part of the micro- or nano-wire (150) in contact with the buffer layer (110), the micro- or nano-wire (150) also having an active zone (152) adapted to receive electromagnetic radiation and convert it into an electrical signal;
- electrical connection means adapted to enable electrical connection of the micro- or nano-wire (15) so as to retrieve the electrical signal;
the structure being **characterized in that** the first zone (110, 111) is composed mainly of magnesium nitride in the form MgₓN_{y}.

12. Method of manufacturing an optoelectric structure (10) wherein the structure is a structure according to claim 10 or 11, said manufacturing method comprising steps to:
- form at least one micro- or nano-wire (150) according to a method of manufacturing micro- or nano-wires (150) according to claim 1 to 8;
- form electrical connection means for the micro- or nano-wire (150).
